# EUROPEAN PATENT APPLICATION

(11) **EP 1 293 587 A1**
(43) Date of publication of application: **19.03.2003**
(21) Application number: 02020390.7
(22) Date of filing: 12.09.2002
(51) Int. Cl.: C23C 14/54, C30B 25/10

(54) **Vacuum coating apparatus with central heater**

(30) Priority: 14.09.2001 JP 2001280520
(71) Applicant: KABUSHIKI KAISHA KOBE SEIKO SHO, Kobe-shi, Hyogo 651-8585 (JP)
(72) Inventor: Tamagaki, Hiroshi,Takasago Works in Kobe Steel Ltd, Takasago-shi, Hyogo 676-8670 (JP)
(74) Representative: Leson, Thomas Johannes Alois, Dipl.-Ing.

(57) **Abstract**

A vacuum coating apparatus is provided, which ensures a high stability and reliability in the operation using the plasma, and which is further capable of operating at a much higher surface temperature of a heater. At least one substrate 8 disposed in a vacuum chamber 1 is heated, and then at least one layer is coated on the surface of the at substrate 8 thus heated, while applying plasma thereto. A long cylindrical hollow element 12 having a bottom wall is disposed in the vacuum chamber 1, and the inside of the hollow element 12 is isolated from the environment in the vacuum chamber 1. The substrate 8 is disposed outside of the hollow element 12 and heated by the radiation emanating from the outer surface of the hollow element 12 which is heated from the inside thereof by means of heating means 14.

## Description

### BACKGROUND OF THE INVENTION

### 1. Field of the Invention

The present invention relates to a coating apparatus, which is used to form a layer on one or more substrates in vacuum.

### 2. Description of the Related Art

An ion plating apparatus in which plasma is used in vacuum, a PVD apparatus of a sputtering apparatus, or a plasma CVD apparatus is known as an apparatus for forming one or more wear resistant layers on a component to be coated, such as a tool or a mechanical part (hereinafter referred to as "substrate").

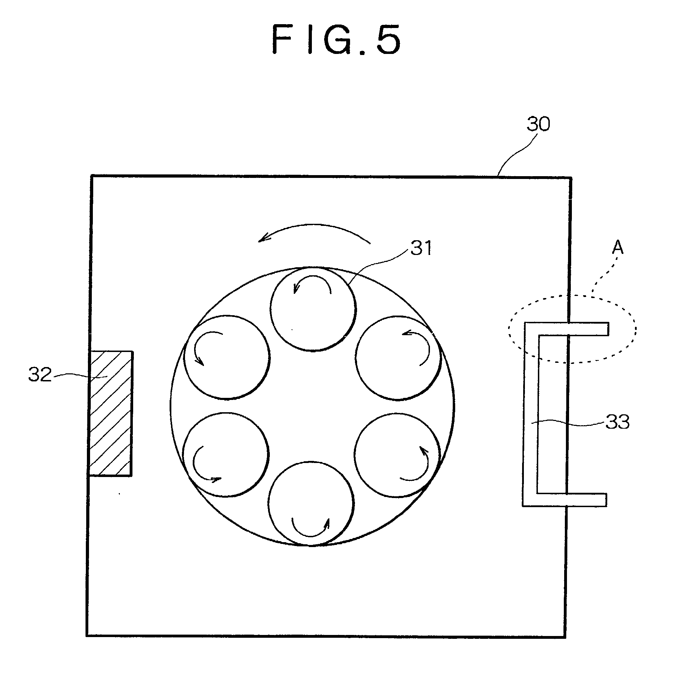

Fig. 5 shows an example of a coating apparatus based on the arc-ion plating method as one of the ion plating methods.

In this apparatus, substrates 31 are disposed in a vacuum chamber 30 which is evacuated to form a vacuum. A coating material is evaporated from an evaporation source 32 in the vacuum chamber 30 and is deposited onto the substrates 31 to form a layer. In this process, the layer is formed while irradiating plasma to the substrates 31, and the plasma is usually generated from the evaporation source 32 or a plasma source other than the evaporation source.

Since a tool or a mechanical part as a substrate 31 has complicated profile, it is mostly necessary to rotate the substrates 31 during the process of coating in order to form a layer having a predetermined uniform thickness and, at the same time, to apply a minus voltage to the substrates 31 in order to improve the properties of the layer.

In such a coating apparatus, it is important to heat the substrates 31 at a predetermined temperature of, for example, 400 to 500 °C in order to obtain a layer having good quality. The heating is carried out with a radiant heater 33 in the vacuum chamber 30 of the coating apparatus. The usage of the radiant heater 33 is due to the fact that there is no effective heating means other than radiation in vacuum and that it is further difficult for the substrates 31 to come into contact with the heater 33 because the substrates 31 are rotated during the process of coating, as described above.

Typically, a sheath heater is used as a radiant heater 33. Alternately, as heating means other than the sheath heater, a heating element disposed directly in the vacuum chamber, a lamp heater or the like can be employed. In any of these heating means, it is necessary to dispose electrodes for supplying electric power in the vacuum chamber 30. This causes a problem that a discharge resulting from the plasma used to assist the process of coating occurs on the electrodes. Moreover, a reduction in the heating efficiency occurs due to the deposition of a layer onto a glass protect tube for the lamp heater, and a deterioration of the insulation occurs due to the deposition of a layer onto the surface of an insulating material.

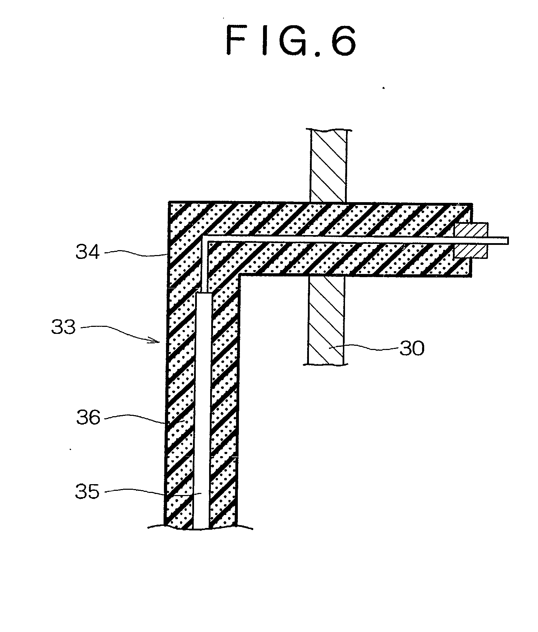

To overcome these problems, the sheath heater 33 can be configurated such that a heating element wire 35 is inserted into the inside of a metal tube (sheath) 34 having a diameter of 10 to 20 mm, and then the inside is filled with an insulating material 36 having both good thermal conductivity and electrical insulation property, and thereafter the tube 34 is bent into a predetermined shape, as shown in Fig. 6. The both ends of the sheath heater 33 pass through the wall of the vacuum chamber, while the vacuum seal is kept by welding or the like, so that the ends of the sheath heater expose in the atmosphere. The electric power is supplied to the heating element 35 from the electrodes in the atmosphere exposed at the both end of the sheath.

The above-described arrangement of the sheath heater 33 provides no exposed electrodes in the chamber 30, thereby causing no problem of discharge when the plasma is generated in the chamber 30. Moreover, the coating material is deposited onto only the outer surface of the metal sheath 34, hence providing no problem regarding the reduction in the insulation.

As a result, the employment of the sheath heater as heating means makes it possible to provide a high stability and a high reliability in the coating apparatus using the plasma.

In the sheath heater, however, there is a problem in which the usable surface temperature is limited to be 800 °C or so. When the surface temperature of the sheath becomes higher than its limit of the, the insulation of the insulating material filled between the sheath and the heating element abruptly deteriorates, thereby causing a large leak current to flow between the sheath and the heating element.

In the conventional method for forming the deposited layer, the substrate is usually maintained at a temperature of 400 - 500 °C under an optimal operation condition. The sheath heater can steadily be operated at such a level of temperature. In recent years, an increasing variety of the depositing requires a higher usable temperature in the coating process. At present, it is impossible to attain a high temperature of, for instance, more than 800 °C, using such a sheath heater, or it is only possible to attain such a high temperature, employing a greater number of sheath heaters.

Moreover, the sheath heater is typically formed by bending the sheath having a very small diameter, so that the finished shape of the heater is complicated. This fact makes it difficult to remove the material deposited onto the surface of the sheath, thereby providing a difficulty in the cleaning of the heater as well as in the maintenance thereof.

### SUMMARAY OF THE INVENTION

It is the object of the present invention to provide a vacuum coating apparatus which ensures a high stability and reliability in the operation using the plasma, and which is further capable of operating at a much higher surface temperature of a heater.

In order to attain the above object, the present invention provides a vacuum coating apparatus for coating a surface of a substrate on heating, comprising a vacuum chamber, a source of coating material disposed in the vacuum chamber, a hollow element disposed in the vacuum chamber, the inside of which is isolated from the environment in the vacuum chamber, and heating means disposed inside of the hollow element for heating the substrate. The substrate in the vacuum chamber is disposed outside of the hollow element and heated by the radiation emanating from the outer surface of the hollow element which is heated from the inside thereof by means of the heating means. The source of coating material can be a evaporation source or a plasma source from which plasma is generated. A coating layer is formed on the surface of the substrate thus heated while irradiating the plasma to the substrate.

The hollow element is preferably formed in the shape of a cylinder having a bottom wall

In accordance with the present invention, the inside of the hollow element, where the heating means are installed, can be isolated from the vacuum environment in the vacuum chamber in which both the coating and plasma irradiation are carried out. Therefore, the same reliability and stability as in the conventional sheath heater can be obtained, and at the same time, a high surface temperature of the heating means can be obtained.

In accordance with the present invention, moreover, the substrates are disposed around the hollow element. Therefore, the space for processing in the vacuum chamber can be effectively used, and further the substrates can be positioned to be very close to the hollow element, hence allowing the substrates to be heated with a high efficiency in the vacuum environment.

It is preferable that the vacuum chamber has an opening and the hollow element is removably inserted in the opening. It is further preferable that hollow element has a flange and the flange can be removably mounted onto the wall of the vacuum chamber.

In such a structural arrangement, the hollow element can easily be removed from its normal position in order to clean it after a fairly thick layer is deposited onto the outer surface of the hollow element during the coating process. In addition, heating means can be inserted with ease into the inside of the hollow element.

Preferably, the heating means should be a heating element capable of being inserted into the inside of the hollow element.

Such a heating element is most simple and effective in operation, because it can be controlled by supplying a current thereto. Moreover, it is preferable that the heating element is disposed apart from the wall surface of the hollow element.

In the structural arrangement, the troubles, such as short circuits and discharges, can be eliminated, and therefore a stable operation can be achieved.

The heating means may also be constituted by a high temperature gas which can be introduced into the inside of the hollow element. Preferably, the high temperature gas is generated by combustion in the inside of the hollow element.

Since the coating layer is formed on the substrates arranged around the hollow element, it is preferable that the evaporation source or the plasma source should be mounted on the wall of the vacuum chamber.

In the arrangement in which the heating apparatus is surrounded by the substrates, the radiation emanating from the heating apparatus can be effectively used to heat the substrates. In the arrangement, furthermore, a space necessary for mounting the evaporation source or the plasma source onto the wall of the vacuum chamber can securely be obtained, and the direct heating of the evaporation source or the plasma source by the radiation emanating from the heating apparatus can also be suppressed.

In another embodiment, a thermal reflector can also be disposed such that it faces the hollow element on a side where no substrates are disposed.

### BRIEF DESCRIPTION OF THE DRAWINGS

Fig. 1 is a longitudinal sectional view of a coating apparatus as an embodiment of the present invention.
Fig. 2 is a plan view of the coating apparatus in Fig. 1.
Fig. 3 is a longitudinal sectional view of a coating apparatus as another embodiment of the present invention.
Fig 4 is a plan view of a coating apparatus as another embodiment of the present invention.
Fig. 5 is a plan view of a coating apparatus in which a conventional sheath heater is used.
Fig. 6 is an enlarged sectional view of part A in Fig. 5.

### DESCRIPTION OF THE PREFERRED EMBODIMENTS

In the following, several embodiments of the present invention will be described in detail, referring to the drawings.

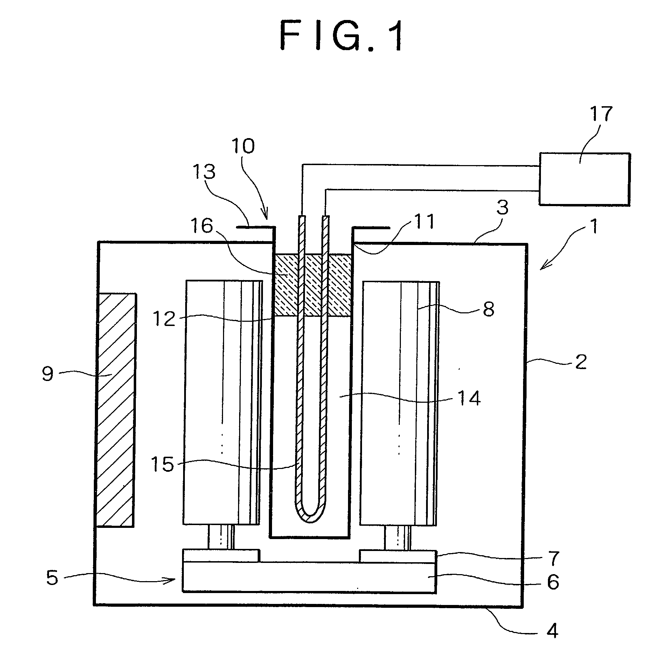

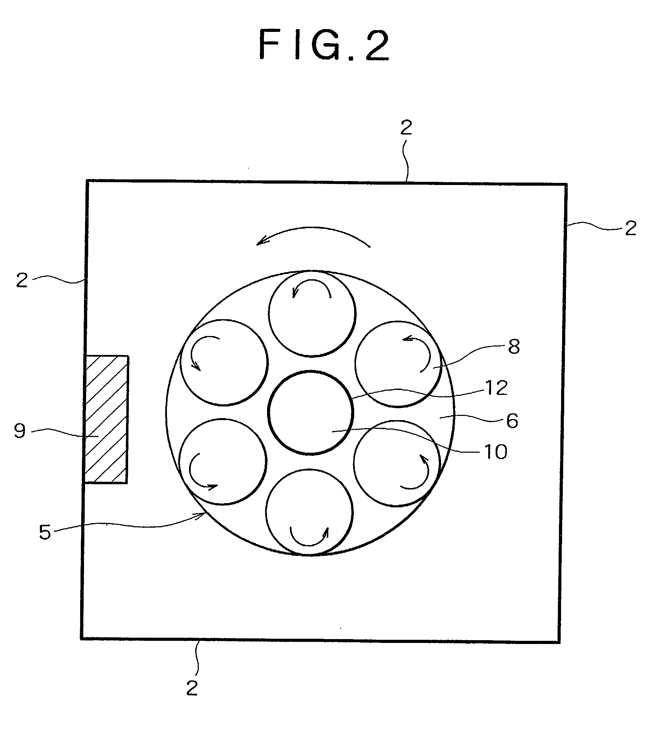

Figs 1 and 2 show a vacuum coating apparatus for forming a layer on substrates with the arc-ion plating method. The coating apparatus includes a vacuum chamber 1 having front, rear, left and right walls 2, an upper wall 3 and a bottom wall 4.

A substrate mounting apparatus 5 is installed inside the vacuum chamber 1. The substrate mounting apparatus 5 includes a rotary table 6 connected to the rotary shaft (not shown), and the shaft is rotatably disposed on the bottom wall 4. A plurality of substrate holders 7, which are disposed in the same spacing on a coaxial circle around the rotary shaft, is disposed on the rotary table 6. Each of the substrate holders 7 can be rotatably mounted onto the rotary table 6 around the corresponding longitudinal rotary shaft of the substrate holder itself. The substrates 8 can be removably mounted on the substrate holders 7. As a result, each substrate 8 is revolved around the rotary center of the rotary table 6, and is further rotated around the rotary center of the corresponding substrate holder 7.

The vacuum chamber 1 is evacuated to form a vacuum by a vacuum pump which is not shown in the drawings. Moreover, a mechanism (not shown) for introducing gas necessary for the coating process into the vacuum chamber 1 may further be implemented therein, if necessary. A vacuum arc evaporation source 9 for evaporating the coating material is implemented on the side wall 2 of the vacuum chamber 1. Power supply units (not shown) for supplying an electric power to the evaporation source 9 and the substrates 8 are disposed respectively. In the process of coating, the coating material is evaporated from the evaporation source 9 and the vapor of the coating material is ionized in the form of plasma to irradiate the substrates 8.

A heating apparatus 10 for heating the substrates 8 is implemented in the vacuum chamber 1.

The heating apparatus 10 includes a hollow element 12 which can be removably inserted into an opening 11 on the upper wall 3 of the vacuum chamber 1. The hollow element 12 is formed in the shape of a cylinder, whose center coincides with the rotary center of the rotary table 6.

The hollow element 12 comprises a long cylindrical body which has a closed wall as a bottom wall for closing at one end and an opening at the other end, A flange 13 having a large diameter is formed in the opening of the cylindrical body at the other end. The flange 13 can be removably mounted on the upper wall 3 of the vacuum chamber 1. The lower end of the hollow element 12 is located at a lower position than the lower end of the substrates 8.

The inside of the hollow element 12 is isolated from the vacuum environment in the vacuum chamber 1 and is connected to the exterior.

A heating means 14 for heating the hollow element 12 is disposed in the inside of the hollow element 12.

The heating means 14 is constituted by a heating element 15, to which an electrical power can be supplied. The heating element 15 is supported via an insulating material 16 by the hollow element 12, so that the heating element 15 is positioned apart from the inner surface of the hollow element 12. The ends of the heating element 15 project outside of the hollow element 12 via the insulating material 16, and an electrical power for heating can be supplied from a power supply 17 to the ends.

In the heating apparatus 10 according to the invention, the heating element 15 is disposed in the atmosphere so that it is completely isolated from the plasma in the vacuum chamber 1, as described above. Therefore, neither extraordinary discharge induced in the heating element 15 due to the generation of plasma, nor the reduction in the insulation resulting from the coated layers any longer occur.

In the heating apparatus 10, a power supply to the heating element 15 causes a heat to generate therein, and the heat thus generated heats the hollow element 12 from the inside thereof by radiation and by transferring the heat due to the air convection in the hollow element 12. The hollow element 12 indirectly heats the substrates 8 by radiation emanating from the side surface of the heated hollow elements.

In this case, such medium (powder of insulating material) as in the sheath heater is not filled between the heating element 15 and the hollow element 12, thereby providing no problem that the insulation is reduced due to the increase in the temperature of the medium. The heating temperature can be increased up to the temperature, which is determined solely from the heat-resistant temperatures of the materials for the heating element 15 and the hollow element 12.

On the contrary to, for instance, the sheath heater having the upper limit surface temperature of 800 °C, when the heat-resistant APM alloy (composition: Fe, Cr, Al) is used as the material of the heating element 15 and the hollow element 12, it is possible to obtain the temperature of 1300 °C which corresponds to the heat-resistant temperature of the material. The heating apparatus according to the present invention provides a much higher efficiency in heating the substrates, since the amount of heat radiation per unit area emanated from the surface of the heating apparatus 10 is proportional to the fourth power of the absolute temperature thereof.

In the aspect of the above-mentioned embodiment, the substrates 8 are arranged such that they surround the heating apparatus 10. As a result, almost all the heat emanated from the heating apparatus 10 may be transferred to the objects to be heated, i.e., the substrates 8, so that the substrates can be heated in high efficiency.

Moreover, since the substrates 8 almost always reside between the evaporation source 9 and the heating apparatus 10, the thermal load applied to the evaporation source 9 can be reduced, and at the same time, the deposit of the material vapor generated from the evaporation source 9 onto the surface of the heating apparatus 10 can be in a minimum amount.

In addition, the hollow element 12 has a simple cylindrical shape, so that, when the coating material is deposited onto the surface thereof, the hollow element can be cleaned much more easily, compared with the sheath heater having a complicated profile.

It is desirable that the hollow element 12 has a cylindrical shape. A shape of polygon tube can also be employed.

It is preferable that the outer surface of the hollow element 12 is coarse in order to enhance the emanating efficiency of radiation.

In accordance with the structural arrangement in the above embodiment, the tube-shaped hollow element 12, the inside of which is isolated from the vacuum environment in the inside of the coating apparatus, is inserted from the upper wall 3 of the vacuum chamber 1. The hollow element 12 is heated from the inside thereof by radiation as well as by both the convection and conduction of the gas filled therein. The heating means 14, which heats the hollow element 12 from the inside thereof, is completely isolated from the environment in the vacuum chamber 1, where the deposition of material and the irradiation of plasma are both carried out. As a result, the heating means has the same high reliability and stability as the sheath heater. Furthermore, the insulating material and the like, which are used for heat conduction, are not filled any longer inside the hollow element 12, thereby enabling a much higher temperature to be achieved without problems of reducing the insulation in the insulating material as encountered in the sheath heater. In conjunction with the above, the hollow element 12 has a simple tube shape, and therefore it can easily be cleaned when the material is deposited on the surface of the hollow element during the coating process.

The hollow element 12 is designed to form a cylindrical body having a bottom wall at one end and a flange 13 at the other end. The flange 13 may be mounted onto the wall surface 3 of the vacuum chamber 1, thereby enabling the inside of the hollow element 12 to be isolated from the vacuum chamber 1. Such a structural arrangement of the hollow element 12 provides an easy insertion of the heating mechanism into the inside of the hollow element 12, and may eliminate the thermal expansion effect of the hollow element on the structure of the coating apparatus.

It is desirable that the hollow element 12 has a cylindrical shape having a circular section. Such a cylindrical structure provides a very small degree of thermal deformation, when the temperature of the hollow element increases. Such a structure ensures to manufacture the hollow element without difficulty, and also to use a small wall thickness for the hollow element 12 which is able to endure a greater pressure difference between the outside and the inside of the hollow element 12. For such a cylindrical hollow element 12, a diameter of at least 30 mm, or more preferably greater than 80 mm, is required to provide a space where the heating means 14 may be inserted into the inside of the hollow element. When, furthermore, taking into account the space in which the substrates 8 are disposed, it is necessary to preset the diameter of the hollow element 12 to be less than half of the inside diameter of the vacuum chamber 1. From the viewpoint of manufacturing the hollow element, using a pipe made of heat-resistant alloy, the diameter should practically be set to be less than 220 mm.

The material for the hollow element 12 has to be selected, taking into account the usable temperature at which the hollow element 12 is operated. The present invention aims to offer a heating apparatus 10 capable of providing a heating temperature of more than 800 °C, which the sheath heater no longer attains. Accordingly, it is desirable that the heating apparatus 10 is constituted by heat-resistant metal or alloy, such as APM alloy, stainless steel, inconel or the like.

The mechanism for heating the hollow element 12 from the inside thereof can be realized most simply by inserting into the inside of the hollow element 12 a heating element 15 to which a current can be supplied. The present invention is not limited to such a structural arrangement. In the heating mechanism according to the invention, the heating element 15 and current supplying portions connected thereto are completely separated from the material depositing area in which the plasma generates, thereby being free from the troubles, such as discharge or the like.

The heating element 15 inserted into the hollow element 12 is disposed spaced from the wall surface of the hollow element 12, so that a stable operation of these elements can be achieved.

The inner space of the hollow element 12 can be filled with air, if there exists no problem due to the oxidization of the heating element 15. However, if there exists a problem due to the oxidization of the heating element 15, the inner space may be filled with the inert gas, such as argon or the like. Furthermore, in order to enhance the efficiency of heat transmission between the heating element 15 and the hollow element 12, the space between these elements can be filled with a gas having a high thermal conductivity, such as He or the like, or it is desirable to fill the space with a gas having a pressure of more than atmospheric pressure.

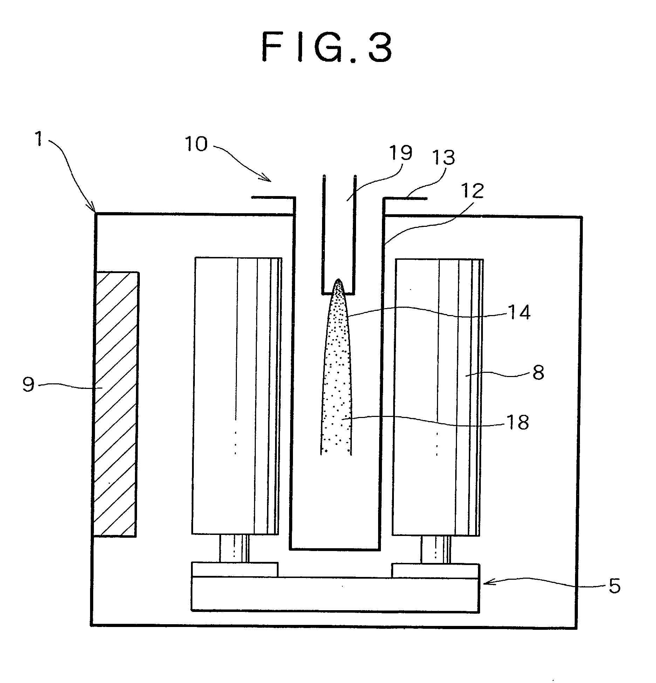

Fig. 3 shows another embodiment of the present invention.

In this embodiment, another mechanism is employed for the heating means 14 in the inside of the hollow element 12.

The heating means 14 comprises a burner 19. The inflammable gas and air are mixed in the inside of the hollow element 12 and then burned with the burner 19. Thus, the hollow element 12 is heated from the inside by the high temperature gas 18 resulting from the combustion. The heating element 15 shown in Fig. 1 can be replaced with the burner 19.

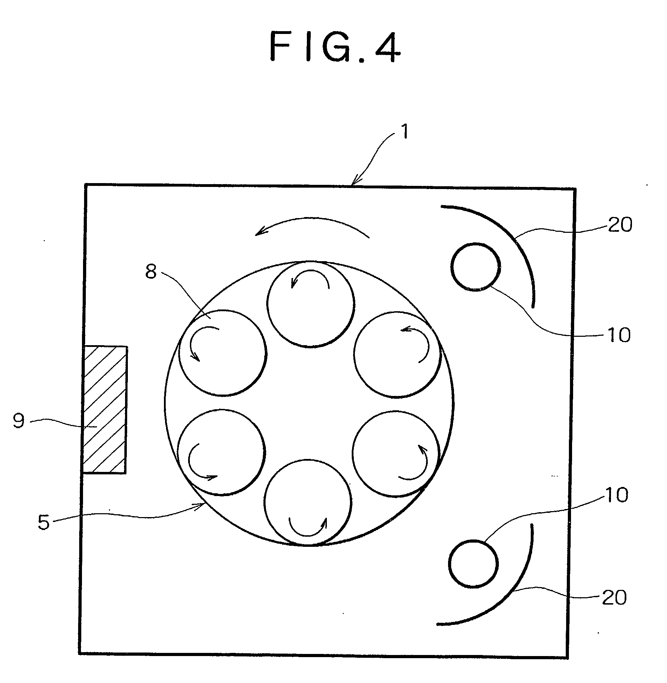

Fig. 4 shows another embodiment of the present invention, in which a plurality of heating apparatuses 10 is disposed in the vacuum chamber 1.

In this embodiment, the substrates 8 are disposed on one side of the heating apparatuses 10, and thermal reflectors 20 are disposed on the side of the heating apparatuses 10 where the substrates 8 are not disposed.

In this embodiment, the heating apparatuses are not surrounded by the substrates 8, and therefore the reflectors 20 for reflecting radiation is disposed on the side where the substrates 8 are not disposed, thereby enabling the radiation emitted toward the other side to be effectively used. In conjunction with the above, it is effective that the outer surface of the heating apparatuses 10, said outer surface facing the substrate 8, is prepared to be coarse, thus allowing to increase the radiation-emitting efficiency, and that the surface of the hollow element, which does not face the substrate 8, is prepared to be smooth like mirror surface, thus allowing to reduce the radiation-emitting efficiency.

Moreover, in order to reduce the radiation emitting efficiency, it is possible to cover the surface of the heating apparatuses 10 with one or more materials each having a reduced efficiency for emitting the radiation, instead of grinding the surface of the heating apparatuses 10.

At the same time, in order to enhance the radiation emitting efficiency, it is possible to cover the surface of the hollow element 12 with one or more materials each having a greater efficiency for emitting the radiation, instead of using the coarse surface of the hollow element 12.

In this embodiment, moreover, the present invention can be applied to a sputtering apparatus by replacing the evaporation source for the arc ion plating with a sputtering evaporation source.

Although various embodiments are described herein in detail, the present invention is not restricted to these.

A vacuum coating apparatus is provided, which ensures a high stability and reliability in the operation using the plasma, and which is further capable of operating at a much higher surface temperature of a heater. At least one substrate 8 disposed in a vacuum chamber 1 is heated, and then at least one layer is coated on the surface of the at substrate 8 thus heated, while applying plasma thereto. A long cylindrical hollow element 12 having a bottom wall is disposed in the vacuum chamber 1, and the inside of the hollow element 12 is isolated from the environment in the vacuum chamber 1. The substrate 8 is disposed outside of the hollow element 12 and heated by the radiation emanating from the outer surface of the hollow element 12 which is heated from the inside thereof by means of heating means 14.

## Claims

1. A vacuum coating apparatus for coating a surface of a substrate on heating, comprising:
a vacuum chamber;
a source of coating material disposed in said vacuum chamber;
a hollow element disposed in said vacuum chamber, the inside of said hollow element being isolated from the environment in said vacuum chamber; and
heating means disposed inside of said hollow element,
wherein the substrate in said vacuum chamber is disposed outside of said hollow element and heated by the radiation emanating from the outer surface of said hollow element which is heated from the inside thereof by means of said heating means.

2. The vacuum coating apparatus according to Claim 1, wherein said hollow element is formed in the shape of a cylinder having a bottom wall

3. The vacuum coating apparatus according to Claim 2, wherein said vacuum chamber has an opening and said hollow element is removably inserted in the opening.

4. The vacuum coating apparatus according to Claim 3, wherein said hollow element has a flange and said flange can removably mounted onto the wall of said vacuum chamber.

5. The vacuum coating apparatus according to Claim 1, wherein said heating means comprises a heating element stored in the inside of said hollow element.

6. The vacuum coating apparatus according to Claim 5, wherein said heating element is disposed apart from the wall surface of said hollow element.

7. The vacuum coating apparatus according to Claim 1, wherein said heating means comprises a high temperature gas which is introduced into the inside of said hollow element.

8. The vacuum coating apparatus according to Claim 7, wherein said high temperature gas is resulting from combustion in the inside of said hollow element.

9. The vacuum coating apparatus according to Claim 1, wherein said substrate is disposed around said hollow element and said source of coating material is mounted on the wall of said vacuum chamber.

10. The vacuum coating apparatus according to Claim 1, wherein a thermal reflector is disposed on the side of said hollow element where said substrate is not disposed.
